# EUROPEAN PATENT APPLICATION

(11) **EP 4 669 036 A1**
(43) Date of publication of application: **24.12.2025**
(21) Application number: 24756772.0
(22) Date of filing: 07.02.2024
(51) Int. Cl.: H05K 3/42, H01P 11/00, H05K 1/02, H05K 3/00, H05K 3/46, H05K 9/00

(54) **PRINTED WIRING BOARD AND METHOD FOR MANUFACTURING PRINTED WIRING BOARD**

(30) Priority: 16.02.2023 JP 2023022333
(71) Applicant: Kyocera Corporation, Kyoto-shi, Kyoto 612-8501 (JP)
(72) Inventor: NAGASE Tomoya, Kyoto-shi, Kyoto 612-8501 (JP); KAWAGOE Atsuo, Kyoto-shi, Kyoto 612-8501 (JP)
(74) Representative: Viering, Jentschura & Partner mbB Patent- und Rechtsanwälte
(86) International application number: PCT/JP2024/004093
(87) International publication number: WO 2024/171924

(57) **Abstract**

A printed wiring board includes a core substrate including a through-hole penetrating from a first surface to a second surface and having an elongated hole shape in a planar view, and a through conductor. In a planar view, the through-hole includes first side walls positioned at both ends and between the both ends to face each other, and second side walls connecting the first side walls and facing each other. In a planar view, the through conductor includes a first conductor positioned along each of the first side walls and having an arc shape, and a second conductor positioned along each of the second side walls and connected to the first conductor. The second conductors includes a protrusion protruding from the second side wall into the through-hole.

## Description

### TECHNICAL FIELD

The present disclosure relates to a printed wiring board and a method of manufacturing the printed wiring board.

### BACKGROUND OF INVENTION

A printed wiring board having a waveguide structure has a shield structure that allows an electromagnetic wave to appropriately propagate in a waveguide portion included in the waveguide structure and reduces leakage of the electromagnetic wave to a region around the waveguide portion. The shield structure in a core substrate can also be constituted by a plurality of through conductors disposed at appropriate intervals in a planar direction of the waveguide portion. In this case, the through conductors are each provided on an inner wall of a through-hole penetrating the core substrate, and are electrically conducted to a ground conductor layer positioned between a plurality of insulating layers.

The through-hole can be easily formed into a circular shape in a planar view. Japanese Unexamined Patent Application Publication No. 2015-139042 discloses through-holes having a diameter and positioning intervals both of which are determined in accordance with a wavelength of an electromagnetic wave propagating in a waveguide portion, to reduce propagation loss of the electromagnetic wave. However, such a shield structure fails to sufficiently achieve effects of reducing leakage of the electromagnetic wave. Proposed in view of this is a through-hole having an elongated hole shape.

### SUMMARY

In an aspect of the present disclosure, (1) a printed wiring board includes a core substrate and a through conductor. The core substrate includes a first surface, a second surface positioned opposite to the first surface, and at least one through-hole. The through-hole penetrates from the first surface to the second surface and has an elongated hole shape in a planar view. The through conductor is positioned along a side wall of the through-hole. The through-hole includes first side walls and second side walls in a planar view. The first side walls are positioned at both ends and between the ends of the through-hole, face each another, and have a first radius of curvature. The second side walls connect the first side walls and face each another. The through conductor includes, in a planar view, a first conductor having an arc shape and positioned along a surface of each of the first side walls, and a second conductor positioned along a surface of each of the second side walls and connected to the first conductor, The second conductor includes a protrusion protruding from the second side wall into the through-hole in a sectional view perpendicular to a longitudinal direction of the elongated hole shape.

(2) In the printed wiring board according to (1) described above, the through-hole includes a first opening opened in the first surface, and a second opening opened in the second surface. The protrusion includes, in the sectional view, an apex portion positioned innermost in the through-hole, a first side extending from the apex portion toward the first opening, and a second side extending from the apex portion toward the second opening. In the sectional view, a first distance from the apex portion to the first opening is longer than a second distance from the apex portion to the second opening.

(3) In the printed wiring board according to (2) described above, a first inclination angle of the first side from the second side wall is larger than a second inclination angle of the second side from the second side wall in the sectional view.

(4) In the printed wiring board according to any one of (1) to (3) described above, the core substrate includes a plurality of insulating layers stacked in a penetrating direction of the through-hole, and an internal conductor layer interposed between the plurality of insulating layers. The internal conductor layer is electrically connected to the through conductor by at least part of a circumference of the through-hole in a plan perspective view.

(5) In the printed wiring board according to (4) described above, the internal conductor layer is a ground conductor layer.

(6) In the printed wiring board according to any one of (1) to (5) described above, the at least one through-hole having the elongated hole shape in the core substrate includes a plurality of through-holes. The through-holes are arranged to surround a rectangular range of the core substrate in a planar view to form a waveguide structure.

(7) In the printed wiring board according to (6) described above, in each of the through-holes having the elongated hole shape, the second conductor is positioned along each side in the range.

(8) In the printed wiring board according to (7) described above, a distance between the through conductors adjacent to each other along each of the sides in the range is 1/10 or less of a wavelength of an electromagnetic wave propagating in the range.

(9) The present disclosure provides a method of manufacturing a printed wiring board. The method includes: preparing a core substrate including a first surface and a second surface positioned opposite to the first surface, and drilling, in the first surface, a plurality of nonthrough-holes having a first diameter and arranged linearly to be separate from each other; drilling, from the second surface, through-holes having a second diameter larger than the first diameter, between the nonthrough-holes and outside the nonthrough-holes positioned at both ends in a plan perspective view, the through-holes being respectively overlapped with part of the nonthrough-holes; forming a through-hole having an elongated hole shape by removing, from the second surface, bottom surfaces of the nonthrough-holes by laser processing; and attaching a through conductor to the through-hole having the elongated hole shape.

### BRIEF DESCRIPTION OF THE DRAWINGS

FIG. 1A is a plan view of a phased array antenna substrate as a printed wiring board according to the present embodiment.
FIG. 1B is a sectional view of the phased array antenna substrate.
FIG. 2A is an explanatory view of a structure of a through-hole.
FIG. 2B includes other explanatory views of the structure of the through-hole.
FIG. 2C is an enlarged explanatory view of the structure of the through-hole.
FIG. 3 is a plan perspective view of a waveguide portion and its vicinity in a core substrate.
FIG. 4A is an explanatory plan view on a first process in a method of forming an elongated through-hole.
FIG. 4B is an explanatory plan view on a second process in the method of forming the elongated through-hole.
FIG. 4C is an explanatory plan view on a third process in the method of forming the elongated through-hole.
FIG. 4D is an explanatory plan view on a fourth process in the method of forming the elongated through-hole.
FIG. 4E is an explanatory plan view on a fifth process in the method of forming the elongated through-hole.
FIG. 5A includes explanatory sectional views on the first process in the method of forming the elongated through-hole.
FIG. 5B includes explanatory sectional views on the second process in the method of forming the elongated through-hole.
FIG. 5C includes explanatory sectional views on the third process in the method of forming the elongated through-hole.
FIG. 6A includes explanatory sectional views on the fourth process in the method of forming the elongated through-hole.
FIG. 6B includes explanatory sectional views on the fifth process in the method of forming the elongated through-hole.

### DESCRIPTION OF EMBODIMENTS

An embodiment will be described hereinafter with reference to the drawings.

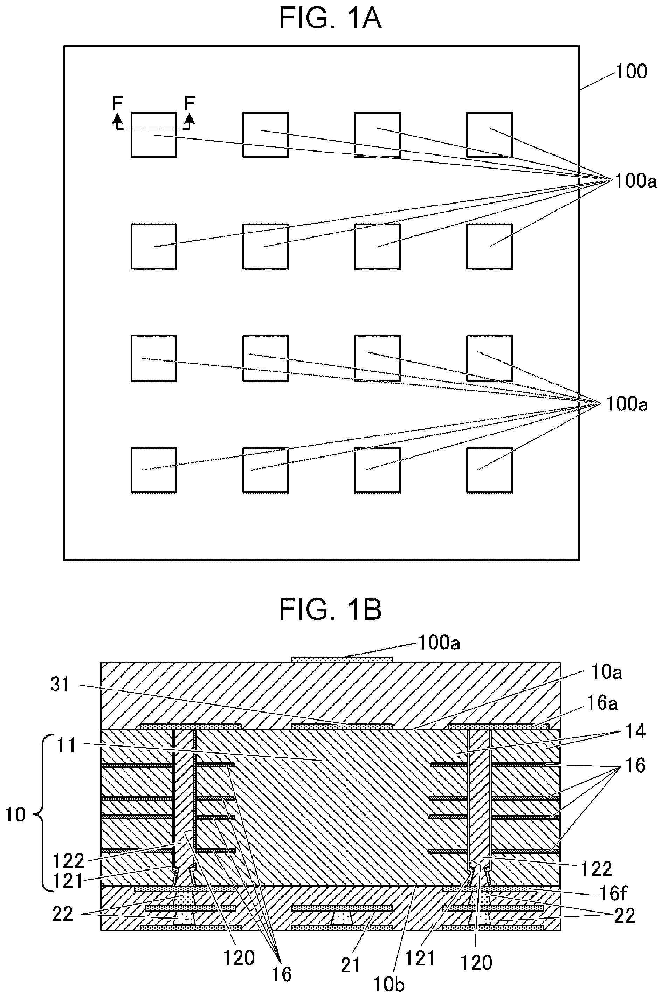

FIGs. 1A and 1B are explanatory views of a phased array antenna substrate 100 as a printed wiring board according to the present embodiment. FIG. 1A is a plan view from above, of the phased array antenna substrate 100 including a core substrate 10. FIG. 1B is a sectional view taken along a section line FF of a certain patch antenna 100a included in the phased array antenna substrate 100.

As illustrated in FIG. 1A, the phased array antenna substrate 100 may include a plurality of patch antennas 100a arranged in a two-dimensional matrix shape. Adjustment in signal phase difference among the patch antennas 100a can determine directivity for transmission and reception of electromagnetic waves of the phased array antenna substrate 100.

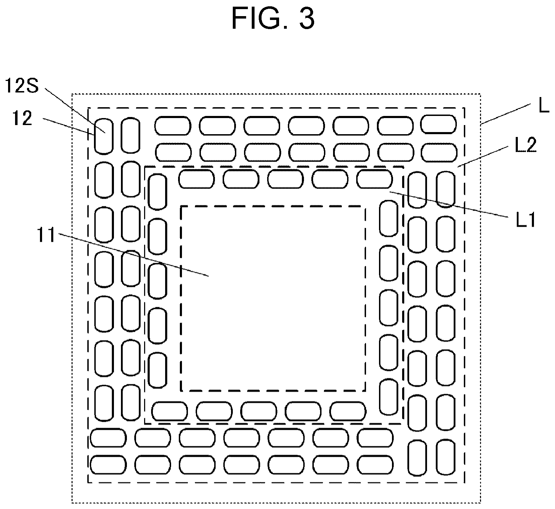

As illustrated in FIG. 1B, in the patch antenna 100a upon electromagnetic wave transmission, an electromagnetic wave radiated from a resonator 21 (antenna) disposed at a low location may travel from a second surface 10b as a lower surface of the core substrate 10 to a first surface 10a as an upper surface opposite to the second surface 10b through a waveguide portion 11, so as to be radiated upward though a radiation pad 31. As illustrated in FIG. 3, the waveguide portion 11 has a rectangular shape in a planar view, and is surrounded with a plurality of shield structures 12S. The waveguide portion 11 and the plurality of shield structures 12S constitute a waveguide structure. The resonator 21 may be connected to a substrate or the like such as an IC chip (not illustrated) positioned adjacent to a bottom surface of the phased array antenna substrate 100. When the IC chip transmits modulated signals (RF signals) to the patch antennas 100a with appropriate phase differences, electromagnetic waves (radio waves) including the signals are transmitted in directions according to the phase differences.

The core substrate 10 includes a plurality of insulating layers 14 being stacked, conductor layers 16 each interposed between the insulating layers 14, a conductor layer 16a positioned on an upper surface of the uppermost insulating layer 14, and a conductor layer 16f positioned on a lower surface of the lowermost insulating layer 14. That is, the conductor layers 16 are internal conductor layers of the core substrate 10. The insulating layers 14 are made of an insulating material that may contain a reinforcer or an inorganic filler and may be any one of known insulating materials applicable to the core substrate 10. The interior of the waveguide portion 11 is made of a resin. The resin may be applied as a component of the insulating layers 14.

The shield structures 12S each include a through conductor 121 positioned along a surface of a side wall in a through-hole 120 penetrating the core substrate 10. The through conductor 121 surrounds an insulating resin 122. Examples of the through conductor 121 may include copper. The insulating resin 122 may be identical to or different from the resin forming the insulating layers 14 or the waveguide portion 11.

At least part of each of the conductor layers 16 may be positioned from between the insulating layers around the through-hole to the through-hole 120, and may be electrically connected to the through conductor 121 on the surface of the side wall in the through-hole 120. Each of the conductor layers 16 serves as a ground conductor layer. The through conductor 121 may thus serve as a ground contact surface electrically connected to the conductor layers 16. The through conductor 121 may be connected to a via hole conductor 22 on the second surface 10b to be connected to an external ground or the like.

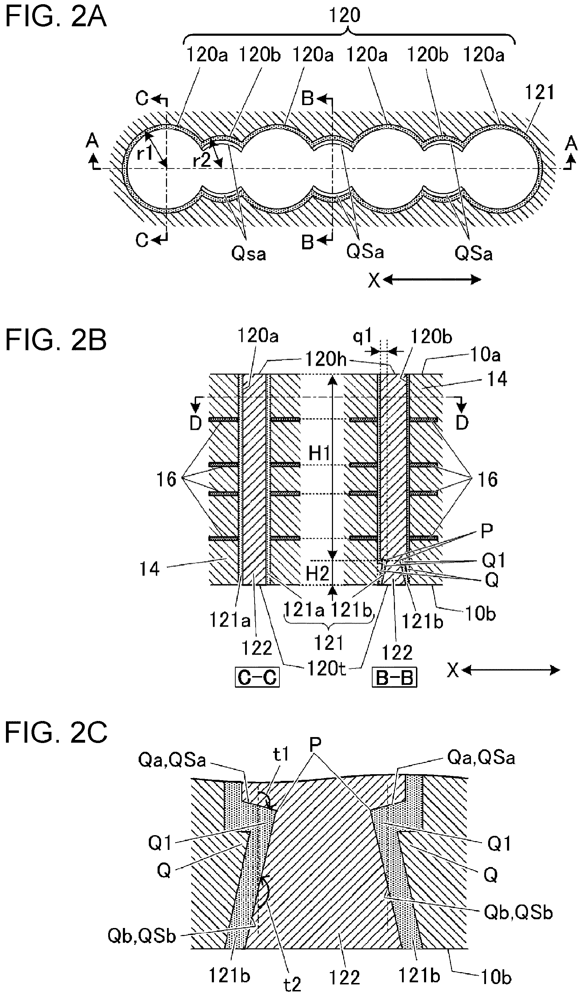

FIG. 2A is a plan view of the through-hole 120 provided with the through conductor 121. FIG. 2B includes sectional views taken along section lines BB and CC in FIG. 2A. FIG. 2C is an enlarged view of protruding sites Q in the sectional view taken along the section line BB in FIG. 2A. The section lines BB and CC each define a plane perpendicular to a longitudinal direction of the through-hole 120.

As illustrated in FIG. 2A, the through-hole 120 has an elongated hole shape extending in an X direction in a planar view. The side wall of the through-hole 120 includes first side walls 120a in an arc shape having a first radius of curvature r1, and second side walls 120b in an arc shape having a second radius of curvature r2 smaller than the first radius of curvature r1 in a planar view, and the first side walls 120a and the second side walls 120b are combined alternately. In other words, each of the second side walls 120b connects the first side walls 120a on both sides. The through-hole 120 has both ends in the X direction in a planar view provided with the first side walls 120a, respectively. FIG. 2A exemplarily includes six first side walls 120a connected via six second side walls 120b. Each of the first side walls 120a faces different one of the first side walls 120a while interposing a hollow portion in the through-hole 120. Each of the second side walls 120b faces different one of the second side walls 120b while interposing the hollow portion in the through-hole 120. The through conductor 121 positioned along the side wall of the through-hole 120 includes first conductors 121a positioned respectively along the first side walls 120a and second conductors 121b positioned respectively along the second side walls 120b. The first conductors 121a and the second conductors 121b each include an arc portion in a planar view, and are connected to each other.

The second side walls 120b each include the protruding site Q protruding into the through-hole 120. The second conductors 121b each include a protrusion Q1 at the protruding site Q. That is, the protrusion Q1 protrudes into the through-hole 120 along the protruding site Q. The second side walls 120b facing each other are provided with a pair of protruding sites Q facing each other. As illustrated in FIG. 2B, in the sectional view along the section line CC, the first side walls 120a and the first conductors 121a along the first side walls 120a each have a linear shape extending from the first surface 10a to the second surface 10b. In the sectional view along the section line BB, the protrusion Q1 protruding into the through-hole 120 is positioned adjacent to a lower end of each of the second side walls 120b, that is, at a position close to the second surface 10b in a penetrating direction of the through-hole 120. The protrusion Q1 includes an innermost portion in the through-hole 120 as an apex portion P illustrated in FIG. 2C. The apex portions P illustrated in FIG. 2B have protruding widths q1 substantially identical on two facing sides.

The protrusion Q1 may be positioned between the lowermost conductor layer 16 and a second opening 120t adjacent to the second surface 10b in openings of the through-hole 120. Accordingly, a first distance H1 from the apex portion P to a first opening 120h adjacent to the first surface 10a in the through-hole 120 is longer than a second distance H2 from the apex portion P to the second opening 120t.

As illustrated in FIG. 2C, each of the protrusions Q1 may have a semitriangular shape in a sectional view including the apex portion P of the protrusion Q1 as a vertex. In a portion closer to the second surface 10b than the apex portion P, a second protruding surface QSb including a second side Qb extends to the second opening 120t at a second inclination angle t2 in a sectional view, so that the through-hole 120 is gradually increased in opening width from the apex portion P. In a portion closer to the first surface 10a than the apex portion P, a first protruding surface QSa including a first side Qa extends at a first inclination angle t1 smaller than the second inclination angle t2 in a sectional view, so that the through-hole 120 is rapidly increased in width in the penetrating direction from the apex portion P. The through-hole 120 is substantially equal in width to the first opening 120h in regions other than the protrusion Q1. The first side Qa is thus shorter than the second side Qb. The protruding surfaces do not need to be strictly flat and may be somewhat uneven. In this case, the first inclination angle t1 and the second inclination angle t2 may be obtained in accordance with the first side Qa and the second side Qb in a sectional view of surfaces obtained by planarly approximating the protruding surfaces.

FIG. 3 is a plan perspective view of the waveguide portion 11 and its vicinity in the core substrate 10 of the phased array antenna substrate 100 as a printed wiring board. A region L surrounding an area of the waveguide portion 11 in the center is provided with a plurality of elongated through-holes 12 having an elongated hole shape in a planar view and arranged, and the elongated through-holes 12 serve as the shield structures 12S. The elongated through-holes 12 each include the through-hole 120 and the through conductor 121 positioned thereinside. In the region L, each of the elongated through-holes 12 has an extending direction X of the elongated hole, that is, a longitudinal direction, which may extend along any side of an outer peripheral portion of a rectangular range of the waveguide portion 11. The through conductors 121 along the side walls of the through-holes 120 thus extend to be arranged along the rectangular range. The elongated through-holes 12 arranged adjacent to each other along the waveguide portion 11, that is, gaps between the through conductors 121 in the through-holes 120, are sufficiently narrow in principle. If the gaps exemplarily have a longest distance corresponding to 1/10 or less of a wavelength of an electromagnetic wave expected to propagate in the waveguide portion 11, the electromagnetic wave is effectively less like to leak through the gaps. A frequency range adopted herein is about 28 GHz to 80 GHz, and the distance between the gaps is approximately slightly less than 1 mm. All the gaps do not need to be uniformized for convenience of arrangement, but the gaps do include any portion wider than 1/10 of the wavelength of the electromagnetic wave expected to propagate.

Furthermore, the elongated through-holes 12 may triply surround the waveguide portion 11 in this case. Gap positioning in a shield structure group L1 including an innermost loop and gap positioning in a shield structure group L2 including second and third loops outside the innermost loop may be displaced along the sides of the waveguide portion 11. An electromagnetic wave leaking through any gap in the shield structure group L1 including the first loop is thus less likely to leak still outside by the shield structure group L2 including the second and third loops. Therefore, these structures can sufficiently reduce leakage of any electromagnetic wave from the waveguide portion 11.

Description is made next to a method of forming the elongated through-holes 12. The elongated through-holes 12 are completed in part of a method of manufacturing a printed wiring board according to the present embodiment in a process of manufacturing the core substrate 10 in the phased array antenna substrate 100 as a printed wiring board. As described above, the core substrate 10 includes the plurality of insulating layers 14 being stacked, the conductor layers 16 each interposed between the insulating layers 14, and the conductor layers 16a and 16f on the surfaces of the insulating layers 14. The core substrate 10 is completed by stacking conductor layers on both sides of each insulating layer, e.g., alternately stacking substrates each provided with copper foil or the like and prepreg as semicured insulating layers or insulating films, and thermocompression bonding these elements, and is prepared prior to formation of the elongated through-holes 12. The conductor layers in a range provided with the through-holes 120 in a planar view may be preliminarily removed from the substrates prior to stacking and thermocompression bonding. Such a range to be removed is not necessarily identical to the range to be eventually provided with the through-holes 120 in a planar view.

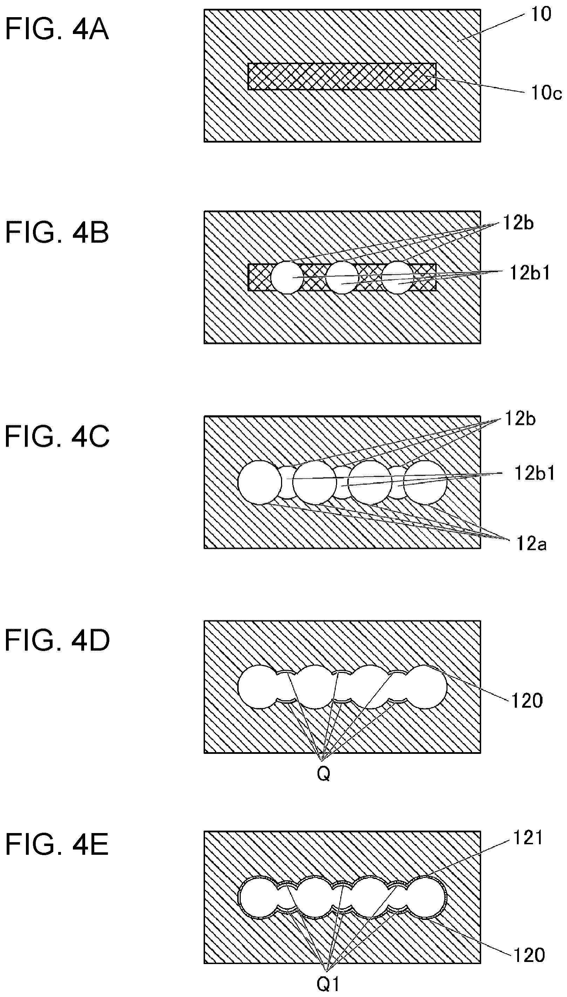

FIGs. 4A to 4E, FIGs. 5A to 5C, FIG. 6A, and FIG. 6B are explanatory views on processes in the method of forming the elongated through-hole 12.

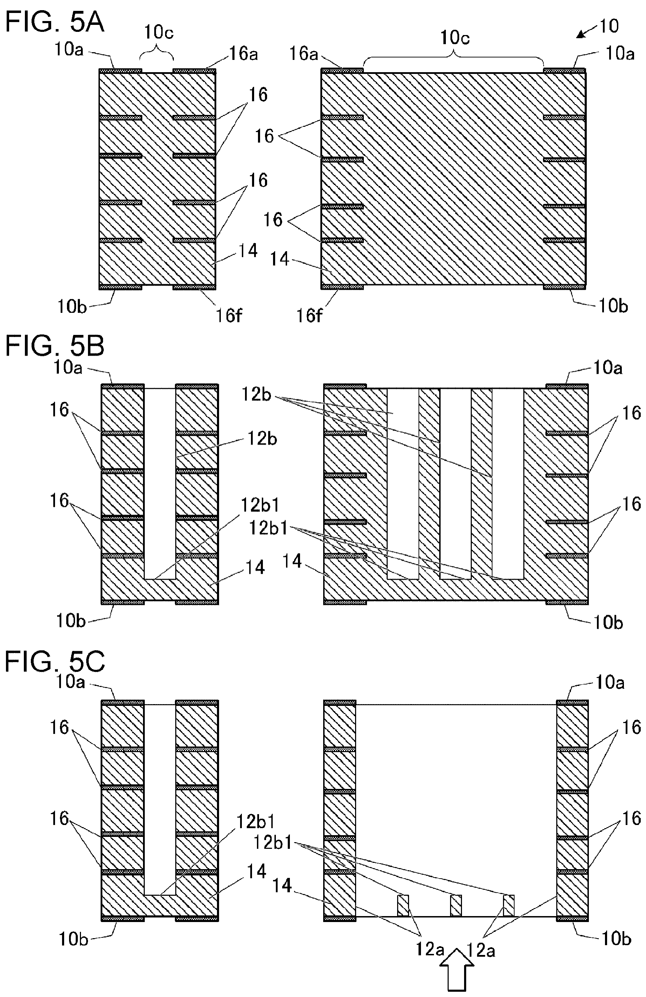

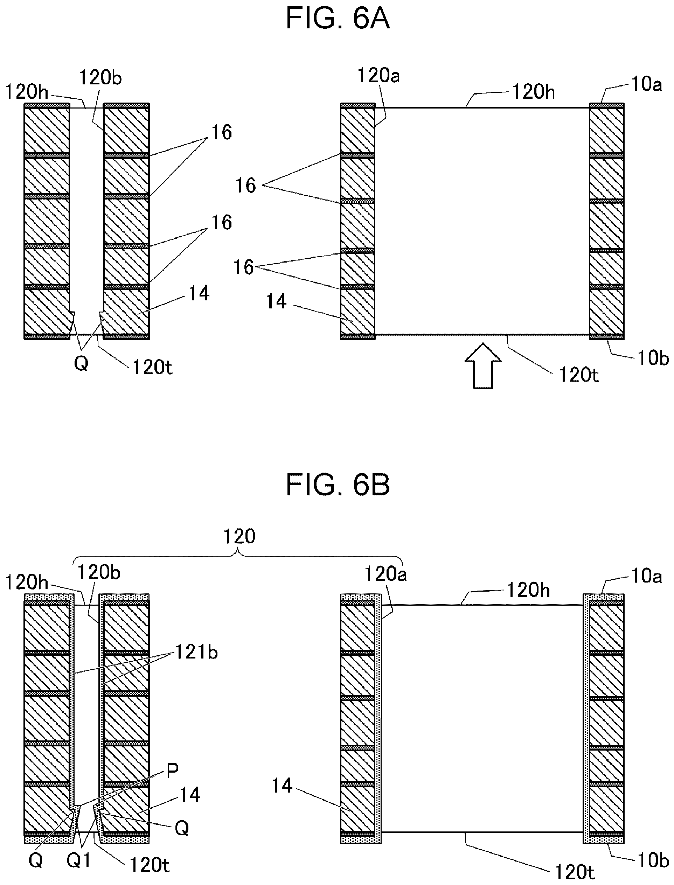

FIGs. 4A to 4E are sectional views parallel to the first surface 10a, of the core substrate 10 taken along a section line DD in FIG. 2B. FIGs. 5A to 5C, FIG. 6A, and FIG. 6B each include sectional views perpendicular to the first surface 10a, of the core substrate 10 taken along the section line BB and a section line AA in FIG. 2A.

FIGs. 4A and 5A each illustrate an insulating region 10c obtained by preliminarily removing the conductor layers 16 during formation of the core substrate 10 as described above.

As illustrated in FIGs. 4B and 5B, a plurality of nonthrough-holes 12b is drilled from the first surface 10a such that centers of the nonthrough-holes 12b are linearly arranged to be separate from each other on a straight line in the insulating region 10c in a planar view. The nonthrough-holes 12b each include an opening having a first diameter twice the second radius of curvature r2. Each of the nonthrough-holes 12b includes a bottom surface 12b1 positioned closer to the second surface 10b than the conductor layer 16 closest to the second surface 10b.

As illustrated in FIGs. 4C and 5C, a plurality of through-holes 12a is drilled from the second surface 10b. The through-holes 12a have centers positioned in a planar view at both ends of the insulating region 10c, that is, outside the nonthrough-holes 12b positioned at the both ends, as well as between the adjacent centers of the nonthrough-holes 12b. The through-holes 12a each include an opening having a second diameter. The second diameter as well as a diameter of a drill used for formation of the through-holes 12a are larger than a diameter of a drill used for formation of the nonthrough-holes 12b, and are twice the first radius of curvature r1. The bottom surfaces 12b1 of the nonthrough-holes 12b are thus partially removed to have an array shape in a planar view.

As illustrated in FIGs. 4D and 6A, remaining portions of the bottom surfaces 12b1 are removed from the second surface 10b by laser processing. An area in a planar view removed by single application of laser processing is less than an area of each of the remaining bottom surfaces 12b1. Laser processing is thus applied several times while moving a position in a planar view for each of the bottom surfaces 12b1. The through-hole 120 is thus formed to have the elongated hole shape including the first opening 120h in the first surface 10a and the second opening 120t in the second surface 10b.

Laser processing generates a tapered shape, so that the through-hole 120 is gradually reduced in width inward to be more distant from the second surface 10b in the penetrating direction. Accordingly, the second side walls 120b of the nonthrough-holes 12b each include the protruding site Q protruding into the through-hole 120. The first side walls 120a of the through-holes 12a have a linear shape in a sectional view as described above.

As illustrated in FIGs. 4E and 6B, the through conductor 121 is attached along the surface of the side wall of the through-hole 120. The through conductor 121 surrounds a portion that may be filled with the insulating resin 122. In this manner, the core substrate 10 is provided with the elongated through-holes 12.

As described above, the phased array antenna substrate 100 as a printed wiring board according to the present embodiment includes the core substrate 10 including the first surface 10a, the second surface 10b positioned opposite to the first surface 10a, and the through-holes 120 having the elongated hole shape in a planar view and penetrating from the first surface 10a to the second surface 10b, as well as the through conductors 121 positioned along the first side walls 120a and the second side walls 120b of the through-holes 120. In a planar view, each of the through-holes 120 includes the first side walls 120a positioned at the both ends and between the both ends of the through-hole 120 to face each other and having the first radius of curvature r1, and the second side walls 120b connecting the first side walls 120a and facing each other. In a planar view, each of the through conductors 121 includes the first conductors 121a positioned along surfaces of the first side walls 120a and having the arc shape, and the second conductors 121b positioned along surfaces of the second side walls 120b and connected to the first conductors 121a. In a sectional view perpendicular to the X direction as the longitudinal direction of the elongated hole shape, the second conductors 121b each include the protrusion Q1 protruding from the second side wall 120b into the through-hole 120.

In a planar view, the core substrate 10 in the phased array antenna substrate 100 thus includes the shapes of the through-holes 120 each formed by connecting ranges of the plurality of through-holes 12a and the plurality of nonthrough-holes 12b. In addition, in a sectional view perpendicular to the longitudinal direction of each of the through-holes 120, each of the second side walls 120b as the connected portions is only partially tapered to have the protruding surfaces characteristic to laser processing, and the remaining portion has the linear shape characteristic to the nonthrough-holes 12b due to drilling. The through-hole 120 is eventually shaped to include the protrusions Q1 each defined by the protruding surfaces. Each of the elongated through-hole 12 formed by the through-hole 120 having such a characteristic shape can be formed accurately, so as to reliably serve as a shield of the waveguide structure.

The protrusions Q1 serve as stoppers when the through conductor 121 is filled with the resin, and the cured resin is less likely to be extracted from the elongated through-hole 12 to be more likely to keep the shape.

The through-hole 120 may include the first opening 120h opened in the first surface 10a and the second opening 120t opened in the second surface 10b. In a sectional view, the protrusions Q1 may each include the apex portion P positioned innermost in the through-hole 120, the first side Qa extending from the apex portion P toward the first opening 120h, and the second side Qb extending from the apex portion P toward the second opening 120t. In a sectional view, the first distance H1 from the apex portion P to the first opening 120h may be longer than the second distance H2 from the apex portion P to the second opening 120t.

In a sectional view, the first inclination angle t1 of the first side Qa to the second side wall 120b may be smaller than the second inclination angle t2 of the second side Qb to the second side wall 120b. The through-hole 120 includes a portion having the first inclination angle t1 to be formed by drilling. A portion formed with use of a drill having excellent throughput is longer than a portion formed by laser processing, so as to shorten processing time. Furthermore, a smaller number of times of laser application can reduce damages to the insulating layers 14 upon removal of the bottom portions of the nonthrough-holes 12b.

The core substrate 10 may include the plurality of insulating layers 14 stacked in the penetrating direction of the through-hole 120, and the conductor layers 16 each interposed between the plurality of insulating layers 14. The conductor layers 16 each include at least part of a circumference of the through-hole 120, which may be electrically connected to the through conductor 121 in a plan perspective view. The through conductor 121 can thus be more stably equalized in potential to an external conductor.

The conductor layers 16 may be the ground conductor layers connected to a ground contact surface during use. The through conductor 121 is thus grounded appropriately. The elongated through-hole 12 relevant to the through-hole 120 thus appropriately serves as the shield structure.

The core substrate 10 may include the plurality of through-holes 120 having the elongated hole shape. In the phased array antenna substrate 100, the plurality of through-holes 120 may be arranged to surround the waveguide portion 11 in the rectangular range of the core substrate 10 in a planar view to achieve the waveguide structure.

The waveguide portion 11 is surrounded with the elongated through-holes 12 corresponding to the through-holes 120 having the elongated hole shape in a planar view, so as to reduce the number of intervals between the through-holes adjacent to each other than exemplary through-holes having a circular shape in a planar view. The phased array antenna substrate 100 can thus more reliably reduce leakage of an electromagnetic wave.

In the plurality of through-holes 120, the through conductors 121 may be positioned along the sides of the waveguide portion 11. Each of the shield structures 12S shields a long range in the longitudinal direction facing the waveguide portion 11, so that the phased array antenna substrate 100 can reduce leakage of an electromagnetic wave efficiently and more reliably.

The through conductors 121 adjacent to each other along the sides of the waveguide portion 11 have a distance therebetween which may be 1/10 or less of the wavelength of the electromagnetic wave propagating in the waveguide portion 11. The electromagnetic wave expected to propagate is less likely to leak through a gap sufficiently short relatively to the wavelength. In particular, a gap corresponding to 1/10 or less of the wavelength can significantly reduce leakage of the electromagnetic wave. With the plurality of through-holes 120 arranged and provided with the through conductors positioned along the side walls at such intervals, the core substrate 10 in the phased array antenna substrate 100 includes the waveguide structure allowing appropriate propagation of an electromagnetic wave.

Each of the through conductors 121 may be positioned along substantially entire side walls including the first side walls 120a and the second side walls 120b in an intermediate portion between the ends of the through-hole 120, and the insulating resin 122 may be positioned inside the through conductor 121. Such a structure can improve reliability of a printed wiring board as well as can efficiently reduce leakage of an electromagnetic wave.

The present embodiment provides a method of manufacturing the phased array antenna substrate 100 as a printed wiring board inclusive of the method of forming the elongated through-hole 12, and the manufacturing method includes the following processes. Preparing the core substrate 10 including the first surface 10a and the second surface 10b located opposite to the first surface 10a, and drilling, in the first surface 10a, the plurality of nonthrough-holes 12b arranged linearly to be separate from each other and having the first diameter. Herein, the first diameter corresponds to twice the second radius of curvature r2. Drilling, from the second surface 10b, the through-holes 12a having the second diameter larger than the first diameter, between the nonthrough-holes 12b and outside the nonthrough-holes 12b positioned at the both ends in a plan perspective view, so as to be respectively overlapped with part of the nonthrough-holes 12b. Herein, the second diameter corresponds to twice the first radius of curvature r1. Removing, from the second surface 10b by laser processing, the bottom surfaces 12b1 of the nonthrough-holes 12b to form the through-hole 120 having the elongated hole shape. Attaching the through conductor 121 to the through-hole 120 having the elongated hole shape.

In the method of forming the elongated through-hole 12 including such processes, the drill is less likely to be pulled to the nonthrough-holes 12b already formed when the through-holes 12a are drilled. This reduces displacement of the drill to improve formation accuracy of the through-hole 120.

Furthermore, the elongated through-hole 12 has, in addition to the both ends, a portion adjacent to the center and substantially equal in opening width to the both ends, so as to be entirely less likely to be reduced in width. This facilitates attachment of the through conductor 121.

Moreover, the formation method enables a significant reduction of the range to be removed by laser processing, and a decrease in length of a reduced range in the penetrating direction of the through-hole 120. Accordingly, a removed position is less likely to be largely displaced from a laser focal point, or the number of times of shifting the laser focal point can be decreased even when such shifting is needed. The method of manufacturing a printed wiring board including the formation method can thus accurately form the shield structures in the elongated hole shape, and can reduce leakage of an electromagnetic wave.

The above embodiment is described exemplarily and can be modified in various manners.

For example, the above embodiment includes removing the bottom surface 12b1 of each of the nonthrough-holes 12b into the arc shape in a planar view along the planar shape of the nonthrough-hole 12b. However, the present invention is not limited to this case. Alternatively, part of the second side walls 120b and the second conductors 121b may have a planar shape somewhat different from the arc shape depending on positioning of the laser focal point.

Furthermore, the through conductor 121 does not need to be in contact with all the conductor layers 16. The through conductor 121 may alternatively be in contact with part of the conductor layers 16. Moreover, each of the conductor layers 16 in contact with the through conductor 121 does not need to be in contact with the entire circumference of the through conductor 121.

There is no particular limitation in the number of the conductor layers 16. The number of the conductor layers 16 may be more than or less than four as exemplified in the embodiment. The conductor layers 16 are not limited in the positions in the penetrating direction. That is, the insulating layers 14 may be varied in thickness. Each of the nonthrough-holes 12b is regardlessly formed to reach a position between the lowermost conductor layer 16 and the second surface 10b. If the lowermost conductor layer 16 is positioned adjacent to the center in the penetrating direction, the nonthrough-holes 12b may be shorter than the nonthrough-holes 12b according to the above embodiment. However, the longer the nonthrough-holes 12b are, the shorter the depth of laser processing is, so as to facilitate the processing.

Although the above embodiment exemplifies the plurality of nonthrough-holes 12b positioned on the straight line, the present invention is not limited to this case. The nonthrough-holes 12b have only to be arranged on a line that may be bent or curved.

The nonthrough-holes 12b may have an interval appropriately determined in accordance with a difference in the radius of curvatures between the nonthrough-holes 12b and the through-holes 12a.

The plurality of elongated through-holes 12 may be arranged appropriately around the waveguide portion 11. The elongated through-holes 12 are not limited to the arrangement exemplified in the above embodiment. Furthermore, the intervals between the elongated through-holes 12 may be set as appropriate.

The core substrate 10 may alternatively be obtained in accordance with a manufacturing method other than the manufacturing method described above. The core substrate 10 may be applied to any object other than the phased array antenna substrate 100.

In addition, specific configurations, structures, materials, sizes, manufacturing processes, and the like exemplified in the above embodiment are changeable as appropriate without departing from the purport of the present invention. The scoped of the present invention includes the scope of the invention recited in the patent claims as well as a scope equivalent thereto.

### INDUSTRIAL APPLICABILITY

The present disclosure is applicable to a printed wiring board and a method of manufacturing the printed wiring board.

### REFERENCE SIGNS

10 core substrate
10a first surface
10b second surface
10c insulating region
11 waveguide portion
12 elongated through-hole
12S shield structure
12a through-hole
12b nonthrough-hole
12b1 bottom surface
14 insulating layer
16, 16a, 16f conductor layer
21 resonator
22 via hole conductor
31 radiation pad
100a patch antenna
120 through-hole
120a first side wall
120b second side wall
120h first opening
120t second opening
121 through conductor
121a first conductor
121b second conductor
122 insulating resin
L region
L1, L2 shield structure group
P apex portion
Q protruding site
Q1 protrusion
QSa first protruding surface
QSb second protruding surface
Qa first side
Qb second side
r1 first radius of curvature
r2 second radius of curvature
t1 first inclination angle
t2 second inclination angle

## Claims

1. A printed wiring board comprising:
a core substrate including
a first surface,
a second surface positioned opposite to the first surface, and
at least one through-hole penetrating from the first surface to the second surface and having an elongated hole shape in a planar view; and
a through conductor positioned along a side wall of the through-hole;
wherein
the through-hole includes, in a planar view,
first side walls positioned at both ends and between the ends of the through-hole, facing each another, and having a first radius of curvature, and
second side walls connecting the first side walls and facing each another, the through conductor includes, in a planar view, a first conductor having an arc shape and positioned along a surface of each of the first side walls, and a second conductor positioned along a surface of each of the second side walls and connected to the first conductor, and
the second conductor includes a protrusion protruding from the second side wall into the through-hole in a sectional view perpendicular to a longitudinal direction of the elongated hole shape.

2. The printed wiring board according to claim 1, wherein
the through-hole includes
a first opening opened in the first surface, and
a second opening opened in the second surface,
the protrusion includes, in the sectional view, an apex portion positioned innermost in the through-hole, a first side extending from the apex portion toward the first opening, and a second side extending from the apex portion toward the second opening, and
in the sectional view, a first distance from the apex portion to the first opening is longer than a second distance from the apex portion to the second opening.

3. The printed wiring board according to claim 2, wherein a first inclination angle of the first side from the second side wall is larger than a second inclination angle of the second side from the second side wall in the sectional view.

4. The printed wiring board according to any one of claims 1 to 3, wherein
the core substrate includes a plurality of insulating layers stacked in a penetrating direction of the through-hole, and an internal conductor layer interposed between the plurality of insulating layers, and
the internal conductor layer is electrically connected to the through conductor by at least part of a circumference of the through-hole in a plan perspective view.

5. The printed wiring board according to claim 4, wherein
the internal conductor layer is a ground conductor layer.

6. The printed wiring board according to any one of claims 1 to 5, wherein
the at least one through-hole having the elongated hole shape in the core substrate includes a plurality of through-holes, and
the through-holes are arranged to surround a rectangular range of the core substrate in a planar view to form a waveguide structure.

7. The printed wiring board according to claim 6, wherein, in each of the through-holes having the elongated hole shape, the second conductor is positioned along each side in the range.

8. The printed wiring board according to claim 7, wherein a distance between the through conductors adjacent to each other along each of the sides in the range is 1/10 or less of a wavelength of an electromagnetic wave propagating in the range.

9. A method of manufacturing a printed wiring board, the method comprising:
preparing a core substrate including a first surface and a second surface positioned opposite to the first surface, and
drilling, in the first surface, a plurality of nonthrough-holes having a first diameter and arranged linearly to be separate from each other;
drilling, from the second surface, through-holes having a second diameter larger than the first diameter, between the nonthrough-holes and outside the nonthrough-holes positioned at both ends in a plan perspective view, the through-holes being respectively overlapped with part of the nonthrough-holes;
forming a through-hole having an elongated hole shape by removing, from the second surface, bottom surfaces of the nonthrough-holes by laser processing; and
attaching a through conductor to the through-hole having the elongated hole shape.
